# EUROPEAN PATENT SPECIFICATION

(11) **EP 0 291 951 B1**
(45) Date of publication and mention of the grant of the patent: **04.08.1993**
(21) Application number: 88107958.6
(22) Date of filing: 18.05.1988
(51) Int. Cl.: H01L 29/64, H01L 29/267, H01L 29/78, H01L 29/62

(54) **A semiconductor field effect transistor using single crystalline silicon carbide as a gate insulating layer**
Halbleiterfeldeffekttransistor mit einer Gitterisolierungsschicht aus monokristallinem Siliziumcarbid
Transistor à effet de champ à semi-conducteur ayant une couche d'isolation de grille en carbure de silicium monocristallin

(30) Priority: 22.05.1987 JP 125135/87
(43) Date of publication of application: 23.11.1988
(73) Proprietor: FUJITSU LIMITED, Kawasaki-shi, Kanagawa 211 (JP)
(72) Inventor: Ito, Takashi, Kawasaki-shi Kanagawa, 214 (JP)
(74) Representative: Schmidt-Evers, Jürgen, Dipl.-Ing.

(56) References cited:
- GB-A- 1 566 072
- IEEE ELECTRON DEVICE LETTERS vol. ELD-8, no. 2, February 1987, pages 48,49; K. FURUKAWA et al.: "Insulated-Gate and Junection-Gate FET's of CVD-Grown beta-SiC"
- PHYSICS AND TECHNOLOGY OF SEMICONDUCTOR DEVICES by A. GROVE, pp. 317-319, pub. J. Wiley & Sons, 1967.

## Description

### BACKGROUND OF THE INVENTION

The present invention relates to an Insulated Gate Field Effect Transistor (IGFET), particularly to an IGFET using single crystal silicon carbide (SiC) for a gate insulating layer of the IGFET.

In the IGFET, a Metal Oxide Semiconductor (MOS) FET has been widely used as an active device in a Very Large Scale Integrated circuit device (VLSI device) such as a memory device, with a high packing density.

In ordinary MOS FET, a single crystal of silicon (Si) is used for the semiconductor substrate and amorphous silicon dioxide (SiO₂) is used for the gate insulating layer. The main reason is that, the SiO₂ gate insulating layer can be fabricated simply by thermally oxidizing the Si substrate, and the property of thus fabricated SiO₂ gate insulating layer, such as dielectric constant and dielectric strength, are excellent for the MOS FET as far as it is used for usual VLSI device such as a memory device having the memory capacity of 1 M bits.

However, recently, the VLSI device is required to have further high packing density as can be seen from a fact that the memory device comes to have the memory capacity of 16 M bits or more. In such case, a large quantity of MOS FETs are required to be fabricated in a single chip, and the device size is also required to be as small as possible. Accordingly, the size of each MOS FET must be extremely small. When the gate length is reduced, the thickness of the SiO₂ gate insulating layer must become thinner in accordance with so called scaling rule. However, as will be stated later, the gate length cannot be reduced so small.

Generally, a drain current of IGFET is inversely proportional to the gate length and the thickness of the gate insulating layer. This is one merit of MOS FET, that is, when the size of the FET is reduced, the driving ability of the drain current increases, resulting in an increase of the operation speed of the MOS FET.

Recently, a MOS FET having an effective gate length of 0.25 µm and a gate insulating layer having 50 Å (1Å = 0.1nm) thickness has been fabricated on an experimental basis. However, in such a MOS FET having so thin SiO₂ gate insulating layer, hot carriers are generated in the channel region, and they penetrate into the gate insulating layer. And problems occur such that carrier mobility decreases, the operation of the MOS FET becomes unstable, and the reliability of the MOS FET decreases.

If a gate voltage could be lowered in proportion to the rate of scaling-down of its size, the foregoing problems due to the thinning of the SiO₂ gate insulating layer would be avoided occurring. However, from a viewpoint of the user of the device, the gate voltage is desirable to be same as those of ordinary ones, for example, in 5 volts (V). Therefore, when the SiO₂ gate insulating layer becomes very thin, the electric field in the SiO₂ gate insulating layer increases. As a result, hot carriers are generated in the channel region and their number increases. These hot carriers tend to penetrate through the SiO₂ gate insulating layer due to the tunnel effect. This incurs an unstable gate voltage and causes unstable operation of the MOS FET.

Further, SiO₂ film is amorphous that includes many surface states at the boundary between the bulk silicon of the substrate and the SiO₂ layer. Due to the interaction with these surface states, the surface electron mobility, which is important to determine the characteristic of the MOS FET, decreases as low as 20% - 40% of the electron mobility in the Si bulk. This is another reason to reduce the operating speed of the MOS FET.

Furthermore, a dielectric breakdown occurs when the electric field applied to the SiO₂ gate insulating layer exceeds 1 x 10⁷ V/cm. Moreover, when the thickness of the SiO₂ gate insulating layer is made thin so as to be less than 20 Å, a direct tunnel current begins to flow through the SiO₂ gate insulating layer.

From these reasons, there is a limit to make the SiO₂ gate insulating layer thin, in other words, the scaling down of the MOS FET is limited.

Moreover, since the material SiO₂ is not so fine, pin holes are actually produced in the material SiO₂ easily. Particularly, as the SiO₂ gate insulating layer is made thinner than 100 Å, the pin holes affect the gate insulating layer so as to make the conductive material in the gate electrode diffuse into the SiO₂ gate insulating layer and sometimes cause the breakdown, electrically leakage or short of the insulating layer.

The material of SiC and its application to the semiconductor device have been studied for a long time, so that many kinds of semiconductor devices using SiC have been developed. However, these study and development have been directed to produce semiconductor devices using carriers in SiC, such as a bipolar transistor, a MOS inverted type FET (see a technical document titled "Application of SiC to Semiconductor Device and its Trend", by Hiroyuki Matsunami, monthly "Semiconductor World", Dec. 1976, Japan), insulated-gate or junction-gate FET (see a technical document "Insulated-Gate and Junction-Gate FET's of CVD-Grown 8-SiC", by k.Furukawa et al., IEEE ELECTRON DEVICE LETTERS, VOL. EDL-8. NO. 2, FEBRUARY 1987). But as far as is known, there has been no idea to use the single crystalline SiC film grown on a single crystalline semiconductor substrate for the gate insulating layer of the FET, replacing the SiO₂ film.

A semiconductor device employing SiC is described in GB- 1566072.

### SUMMARY OF THE INVENTION

Considering the above problems of the MOS FET, the present invention intends to offer a novel IGFET enabling the higher speed operation and circuit integration of the semiconductor device to realize, compared with the prior art MOS FET.

An object of the present invention, therefore, is to provide an IGFET having a smaller size than that of the prior art MOS FET comprising the Si substrate and the SiO₂ gate insulating layer.

Another object of the present invention is to provide an IGFET having a transconductance higher than that of the prior art MOS FET.

Still another object of the present invention is to provide an IGFET stably operating in higher speed than that of the prior art MOS FET.

A further object of the present invention is to provide an IGFET having stable reproducibility with high reliability in fabrication, even though the size of the IGFET is smaller than that of the prior art MOS FET.

Yet another object of the present invention is to provide an IGFET having a dielectric breakdown voltage higher than that of the prior art MOS FET, even though the size of the IGFET is smaller than that of the prior art MOS FET.

The above objects are accomplished by providing an IGFET with a gate insulating layer comprising a single crystalline SiC layer epitaxially grown on the single crystalline Si substrate, instead of the amorphous SiO₂.

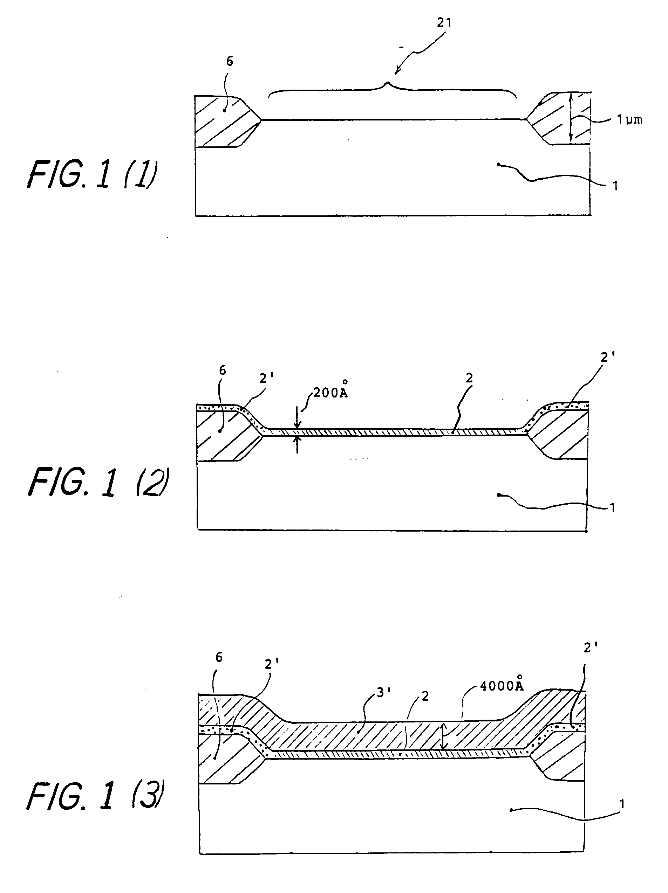

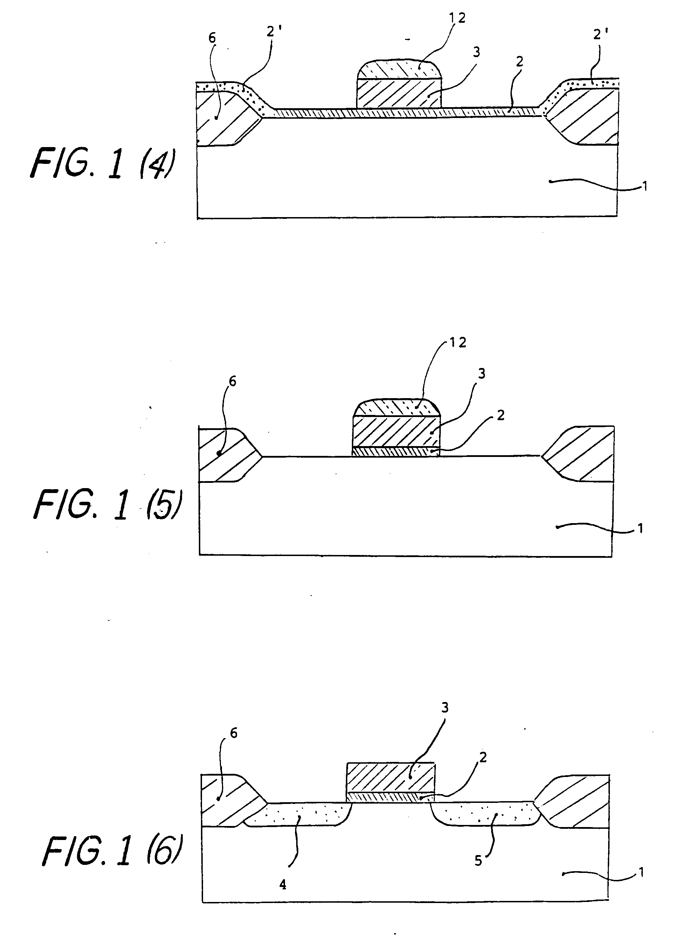

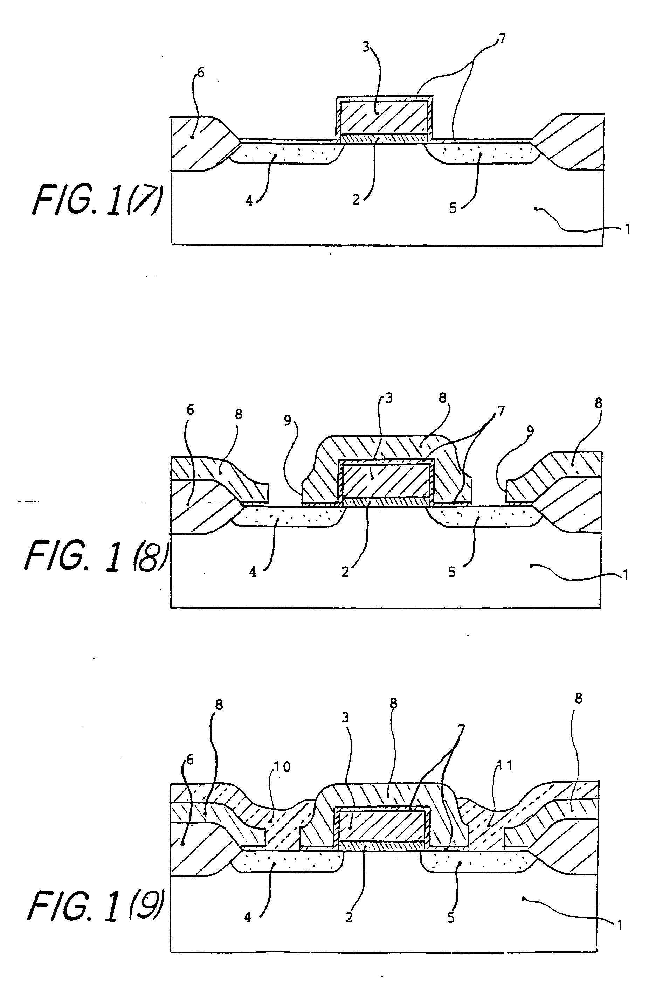

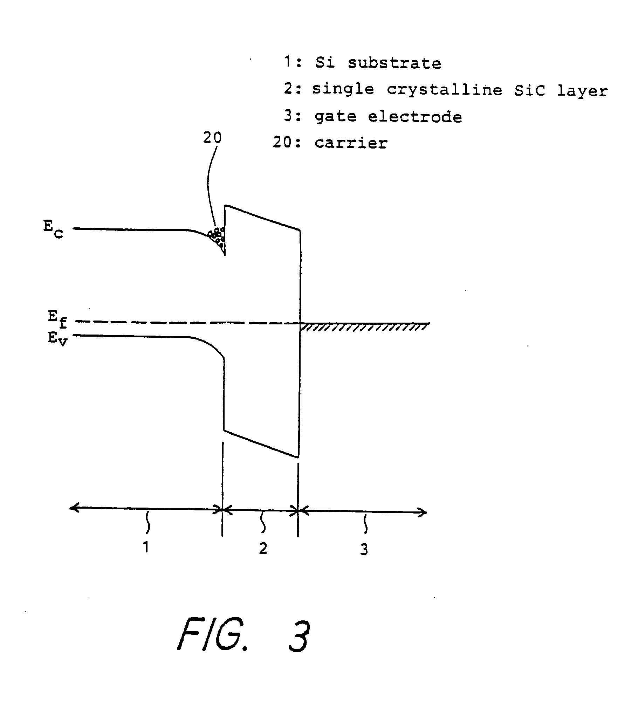

According to the present invention, an undoped single crystalline silicon carbide (SiC) film 2 having a high resistivity is formed over a p type Si substrate 1 for example, forming an interface between Si and SiC, which will be called an "Si/SiC interface" hereinafter and a gate electrode 3 is formed on the the SiC film 2, as shown in Fig. 1(9). Since the forbidden band gap in SiC is larger than that of Si, the energy level of the Si/SiC interface will become as shown in Fig. 3. Electrons in this case are trapped in a potential well formed at the Si side surface of the Si/SiC interface, and operate as the carriers in the channel of the IGFET. Such situation is similar to ordinary FETs using SiO₂ gate oxide film.

The single crystalline SiC for the gate insulating layer can be formed on the single crystalline Si substrate, applying a vapor phase epitaxial method by using low pressurized gas containing an Si source gas such as silicon tetrachloride (SiCl₄), trichlorosilane (SiHCl₃) or monosilane (SiH₄) and a C source gas such as carbon tetrachloride (CCl₄), acetylene (C₂H₂) or propane (C₃H₈), at a growth temperature under 1,000°C.

The dielectric constant of SiC is approximately 10 which is two and a half times as large as that of SiO₂. Therefore, the capacitance of the gate structure with a SiC layer can be increased two and a half times as large as that of the SiO₂ gate insulating layer. So, in the channel of the invented IGFET, two and a half times as many as carriers in the MOS FET can be stored. As a result, the drain current of the IGFET increases, and the current drive ability of the IGFET, which is indispensable for raising up the operation speed of the VLSI device, can be increased.

Changing the view point, if the SiC gate insulating layer is required to have the same drain current as that of ordinary MOS FET, the thickness of the SiC gate insulating layer can be allowed to be two and a half times as thick as that of the SiO₂ gate insulating layer. Therefore, the electric field strength in the SiC gate insulating layer decreases 1/2.5 time as small as that in the SiO₂ gate insulating layer. Accordingly, the dielectric breakdown voltage of the invented IGFET increases two and a half times as much as that of conventional FETs.

Since SiC for the gate insulating layer of the invented IGFET is a single crystal, the defects acting as carrier traps in it are few, much less than those in the amorphous SiO₂ gate insulating layer. This reduces the chance that the defects trap the carriers or interfere the drift motion of the carriers in the channel. And, since SiC is a single crystal, the Si/SiC interface can be made flat in the order of an atomic layer and the defect can be reduced at the Si/SiC interface. So, the surface electron mobility can be increased, and the invented IGFET can operate in a high speed.

Since SiC has large thermal conductivity such as 0.4 W/cm· K, the SiC gate insulating layer is mechanically stable in a high temperature. And since single crystalline SiC has fine structure in comparison with amorphous SiO₂, the deterioration of the IGFET characteristic due to diffusion of the gate electrode material into the gate insulating layer or penetration of the gate electrode material through pin holes in the SiC insulating layer, can be avoided occurring during the fabrication process or long operation of the IGFET.

### BRIEF DESCRIPTION OF THE DRAWING

Fig. 1(1) is a cross-sectional view showing a fabrication step, for defining a device area, of a field effect transistor embodying the present invention;
Fig. 1(2) is a cross-sectional view showing a fabrication step, for growing a single crystalline SiC layer on a single crystalline Si substrate, of the field effect transistor embodying the present invention;
Fig. 1(3) is a cross-sectional view showing a fabrication step, for depositing a polysilicon layer for a gate electrode on the SiC layer, of the field effect transistor embodying the present invention;
Fig. 1(4) is a cross-sectional view showing a fabrication step, for removing an unnecessary part of the polysilicon layer to form the gate electrode, of the field effect transistor embodying the present invention;
Fig. 1(5) is a cross-sectional view showing a fabrication step, for etching off an unnecessary part of the SiC layer to form the gate structure, of the field effect transistor embodying the present invention;
Fig. 1(6) is a cross-sectional view showing a fabrication step, for implanting dopants into the Si substrate for forming source and drain regions in the Si substrate, of a field effect transistor embodying the present invention;
Fig. 1(7) is a cross-sectional view showing a fabrication step, for forming an SiO₂ film over the entire surfaces of the device and for activating the dopants in the source and drain regions, of a field effect transistor embodying the present invention;
Fig. 1(8) is a cross-sectional view showing a fabrication step, for covering a phosphosilicate glass (PSG) layer over the device structure and for making source and drain contact holes, of a field effect transistor embodying the present invention;
Fig. 1(9) is a cross-sectional view of the field effect transistor embodying the present invention;
Fig. 2 is a figure showing a temperature and gas flow program for carrying out the epitaxial growth of the SiC layer of the field effect transistor embodying the present invention; and
Fig. 3 is an energy band diagram of an SiC/Si interface formed on a p type Si substrate.

### DESCRIPTION OF THE PREFERRED EMBODIMENT

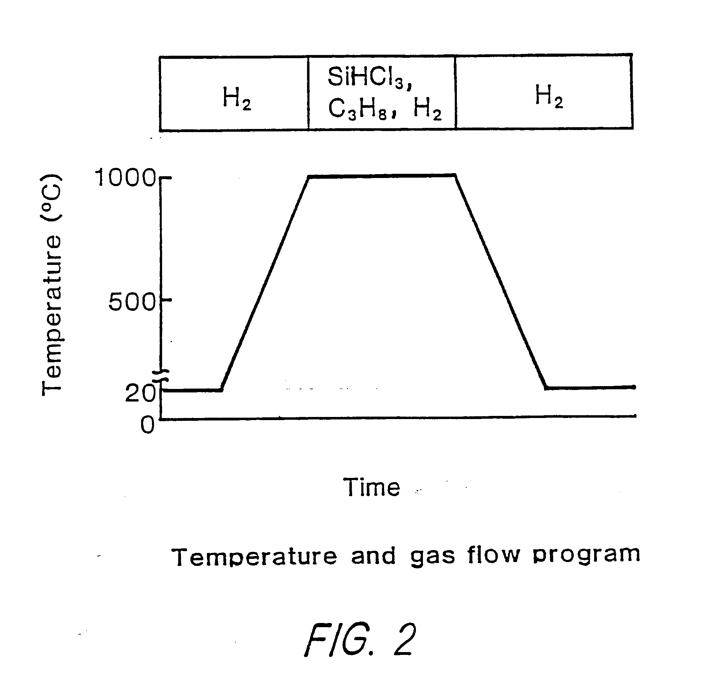

An n-channel IGFET embodying the present invention is fabricated by the following steps, correspondingly referring to Figs. 1(1) to 1(9).
(1) A field oxide film 6 of SiO₂ for defining a device area 21 is formed to 1 µm thickness over the surface of a boron (B) doped p type Si substrate 1 having conductivity of 10 Ω/cm, by a conventional LOCOS (Local Oxidation of Silicon) method using silicon nitride (Si₃N₄) film as a mask. Wherein, the (100) oriented Si substrate is provided so as to form an epitaxial single crystalline SiC layer 2 thereon as will be stated in the next step (2).
(2) A single crystalline SiC layer 2 of 200 Å thickness is epitaxially grown on the surface of the Si substrate 1, as shown in Fig. 1(2), using VPE (Vapor Phase Epitaxial) technology. The epitaxial growth of the SiC layer is carried out in accordance with a temperature and gas flow program as shown in Fig. 2, using the SiHCl₃ gas as an Si source, the C₃H₈ gas as a C source and hydrogen (H₂) gas as carrier gas under a gas pressure of 200 Pa. The H₂ gas is introduced at a flow rate of 7 l/min into a reaction chamber in which the substrate is loaded, and the temperature of the substrate is raised at a rate of 50 K /min. When the temperature has been raised up to 1,000 °C, the SiHCl₃ and C₃H₈ gases are added to the H₂ gas at a flow rates of 0.7 l/min and 38 cc/min respectively. Under this condition, the single crystalline SiC layer 2 is grown on the surface of the Si substrate 1, and a polycrystalline SiC layer 2′ is grown on the surface of the field oxide film 6, as shown in Fig. 1(2). The growth time is approximately 60 sec for obtaining 200 Å thickness of the single crystalline SiC layer 2. Then the flow of the SiHCl₃ and C₃H₈ gases are stopped, remaining the H₂ gas flow, and the temperature is lowered at a rate of 100 K /min. The sheet resistivity of the single crystalline SiC layer 2 is 1,000 Ω/□ when the thickness is 200 Å.
(3) Next, a polysilicon layer 3′ of 4,000 Å thickness is deposited on the surface of the SiC layer 2 as shown in Fig. 1(3), by CVD (Chemical Vapor Deposition) technology. After that, As⁺ ion is implanted into the polysilicon 3′ at a dose of 1 x 10¹⁶/cm² under an accelerating voltage of 70 KeV. The substrate is then annealed at 950°C for 20 min to activate the deposited polysilicon 3′ so that the polysilicon 3′ has a sheet resistance from 50 to 100 Ω/□.
(4) The surface of the polysilicon 3′ is covered by a photoresist film 12, and the photoresist film 12 is patterned by a conventional photolithography, leaving a portion to cover a gate electrode 3. Then, as shown in Fig. 1(4), the polysilicon layer 3′ exposed from the photoresist film 12 is removed, by RIE (Reactive Ion Etching). A gas mixture of carbon tetrachloride (CCl₄) and boron trichloride (BCl₃) at the same ratio is used for etching.
(5) Next, the single crystalline SiC layer 2 and polycrystalline SiC layer 2′ exposed from the polysilicon layer 3′ is etched off by RIE, using an etching gas of carbon tetrafluoride (CF₄) and oxygen (O₂) with a volume ratio 95 : 5. Thus, the structure for a gate electrode 3 is finally formed as shown in Fig. 1(5).
(6) After removing the photoresist film 12 on the gate electrode 3 by plasma ashing for example, source and drain regions 4 and 5 are doped to be n type as shown in Fig. 1(6), by implanting 1 x 10¹⁴ ∼ 1 x 10¹⁵/cm² dose of As⁺ ions into the Si substrate 1 with a 40 KeV accelerating voltage. After that, the substrate 1 is annealed at a temperature of 1,000°C for 10 sec, by RTA (Rapid Thermal Annealing) technology using an infrared lamp.
(7) Subsequently, an SiO₂ film 7 is formed over the entire surfaces of the device by thermal oxidation. By this step, the surfaces of the source and drain regions 4 and 5 and the upper and side surfaces of the gate electrode 6 are covered by thin SiO₂ layer as shown in Fig. 1(7). At the same time, by this step, the dopants implanted by the step (6) are activated, and source and drain regions are formed in the substrate 1.
(8) Next, as shown in Fig. 1(8), the surface of the device structure is covered with a PSG (Phosphosilicate Glass) layer 8 of 1 µm thick by a conventional CVD method, and contact holes 9 for the source and drain electrodes are made respectively on the source and drain regions 4 and 5 through the PSG 8, by a combination of a photolithography and an etching technique.
(9) Finally, the source and drain electrodes are formed with Al-Si(2%) (aluminum silicon alloy including 2% of Si in weight) regions 10 as shown in Fig. 1(9), by usual photolithography and etching.

In the above disclosure, the Si substrate having a (100) orientation has been used. It has been ascertained, that the (111) oriented substrate can be used without any modification of the steps (1) through (9) described above. Using a substrate having a (111) surface orientation is effective for reducing the surface imperfection.

The device characteristics of the invented IGFET having a gate length of 1 µm, a gate width of 10 ηm and a thickness of the gate insulation layer of 200 Å were compared with that of the conventional MOS FETs with SiO₂ gate insulation layers and having the same dimension. The transconductance of the IGFET by the present invention showed 100 metre ohms (mS/mm) in average. While the transconductance of the ordinary FETs were 50 metre ohms (20mS/mm) on average. This difference reflects the expected effect of the SiC gate insulation layer.

The invention have been described with respect to a preferred embodiment. However, it will be apparent for the one skilled in the art that, the dimensions of the devices and the materials of the dopants are not restricted to those described above, further the process technology such as ion implantation, reactive ion etching etc, can be replaced to any preferred ones of the state-of-the-art suitable for the design of the IGFET to be fabricated. For example, the source and drain regions may be formed by the diffusion process. Moreover, not only the polysilicon but also metal such as aluminum, refractory metal like tungsten (W) or molybdenum (Mo), silicide of the refractory metal and a combination of polysilicon and the silicide can be used for the gate electrode.

It will be also apparent that in this embodiment, the n-channel FET has been explained, however, the present invention can be applied also to a p-channel FET by proper choice of conductivity type of the dopants.

## Claims

1. An insulated gate field effect transistor (IGFET) comprising
a single crystalline silicon substrate (1);
a gate insulating layer of single crystal silicon carbide (2) epitaxially grown on the surface of said silicon substrate (1);
a gate electrode (3) formed on said gate insulating layer for forming a channel region in the surface region of said silicon substrate (1) and under said gate electrode through said gate insulating layer;
a source region (4) formed in the surface region of said silicon substrate (1) so as to be electrically connected with an end of said channel region; and
a drain region (5) formed in the surface region of said silicon substrate (1) so as to be electrically connected with the other end of said channel region,
**characterized in that**
said silicon substrate (1) has a major surface of (111) orientation.

2. An insulated gate field effect transistor according to claim 1,
**characterized in that**
said silicon carbide layer (2) is a layer epitaxially grown on said silicon substrate (1) by a vapor phase epitaxial growth method.

## Patentansprüche

1. Isolierschicht-Feldeffekttransistor (IGFET) mit
einem monokristallinen Silizium Substrat (1);
einer Gate-Isolierschicht eines Monokristall-Siliziumcarbids (2), das epitaxial auf die Oberfläche des Silizium Substrats (1) aufgewachsen ist;
einer Gate-Elektrode (3), die auf der Gate-Isolierschicht ausgebildet ist, um einen Kanalbereich im Oberflächenbereich des Silizium Substrats (1) und unter der Gate-Elektrode durch die Gate-Isolierschicht zu bilden;
einem Source-Bereich (4), der im Oberflächenbereich des Silizium Substrats (1) ausgebildet ist, so daß er mit einem Ende des Kanalbereichs elektrisch verbunden ist; und
einem Drain-Bereich (5), der im Oberflächenbereich des Silizium Substrats (1) ausgebildet ist, so daß er mit dem anderen Ende des Kanalbereichs elektrisch verbunden ist,
**dadurch gekennzeichnet, daß**
das Silizium Substrat (1) eine (111) Hauptoberflächenorientierung hat.

2. Isolierschicht-Feldeffefrtransistor nach Anspruch 1,
**dadurch gekennzeichnet, daß**
die Siliziumcarbid-Schicht (2) eine Schicht ist, die epitaxial auf das Silizium Substrat (1) mittels Dampfphasen-Epitaxie-Aufwachstechnik aufgewachsen ist.

## Revendications

1. Transistor à effet de champ à grille isolée (IGFET) comprenant :
un substrat en silicium monocristallin (1) ;
une couche d'isolation de grille en carbure de silicium monocristallin (2) obtenue par croissance épitaxiale sur la surface dudit substrat en silicium (1) ;
une électrode de grille (3) formée sur ladite couche d'isolation de grille pour former une région de canal dans la région de surface dudit substrat en silicium (1) et au-dessous de ladite électrode de grille au travers de ladite couche d'isolation de grille ;
une région de source (4) formée dans la région de surface dudit substrat en silicium (1) de manière à être connectée électriquement à une extrémité de ladite région de canal ; et
une région de drain (5) formée dans la région de surface dudit substrat en silicium (1) de manière à être connectée électriquement à l'autre extrémité de ladite région de canal,
caractérisé en ce que :
ledit substrat en silicium (1) comporte une surface principale d'orientation (111).

2. Transistor à effet de champ à grille isolée selon la revendication 1, caractérisé en ce que ladite couche en carbure de silicium (2) est une couche obtenue par croissance épitaxiale sur ledit substrat en silicium (1) au moyen d'un procédé de croissance épitaxiale en phase vapeur.
